# EUROPEAN PATENT APPLICATION

(11) **EP 4 216 272 A1**
(43) Date of publication of application: **26.07.2023**
(21) Application number: 21938795.8
(22) Date of filing: 09.08.2021
(51) Int. Cl.: H01L 23/528, H01L 23/535, H01L 21/60, H01L 21/768

(54) **GRAPHIC UNIT STRUCTURE AND GRAPHIC ARRAY STRUCTURE**

(30) Priority: 28.04.2021 CN 202110469578
(71) Applicant: Changxin Memory Technologies, Inc., Hefei City, Anhui 230000 (CN)
(72) Inventor: LEE, Tzung-han, Hefei, Anhui 230000 (CN); HUANG, Hsin-pin, Hefei, Anhui 230000 (CN)
(74) Representative: Lavoix
(86) International application number: PCT/CN2021/111508
(87) International publication number: WO 2022/227330

(57) **Abstract**

The present application discloses a patterned element structure and a patterned array structure. The patterned element structure includes a first patterned structure (10), a second patterned structure (20), and a third patterned structure (30), where the first patterned structure (10) includes a first part (11) and a second part (12) that are perpendicular to each other, and a tail end of the first part (11) of the first patterned structure (10) is connected to a head end of the second part (12) of the first patterned structure (10); orthographic projection of a first interconnection structure (13) on the first patterned structure (10) is located in the second part (12) of the first patterned structure (10); the second patterned structure (20) includes a first part (21) and a second part (22) that are perpendicular to each other.

## Description

The present application claims the priority to Chinese Patent Application No. 202110469578.1, titled "PATTERNED ELEMENT STRUCTURE AND PATTERNED ARRAY STRUCTURE", filed with the China National Intellectual Property Administration on April 28, 2021, which is incorporated herein by reference in its entirety.

### Technical Field

The present application relates to the technical field of semiconductors, and in particular, to a patterned element structure and a patterned array structure.

### Background

With the rapid development of semiconductor storage technologies, the market has put forward a higher requirement for a storage capability of a semiconductor storage product. For a dynamic random access memory (DRAM), in a back end of line (BEOL) process, multiple adjacent metal layers along a vertical direction are electrically connected via interconnection structures to complete wafer preparation.

However, in a conventional patterned structure with a BEOL layout, a spacing between patterned structures provided with interconnection structures is excessively wide. After the BEOL layout is completed, a passivation layer is deposited to complete wafer preparation. During a reliability test, for example, an unbiased high accelerated stress test (UHAST), in a high temperature and high humidity environment, voids appear in the passivation layer due to an excessively wide spacing area, and the voids will cause an interconnection structure to fall off. Consequently, a prepared wafer is seriously aged, and fails in the reliability test.

### Summary

A first aspect of the present application proposes a patterned element structure, including:
a first pattern, where the first pattern includes a first part and a second part that are perpendicular to each other, a tail end of the first part of the first pattern is connected to a head end of the second part of the first pattern, and the second part of the first pattern extends along a first direction; and orthographic projection of a first interconnection structure on the first pattern is located in the second part of the first pattern;
a second pattern, where the second pattern includes a first part and a second part that are perpendicular to each other, a tail end of the first part of the second pattern is connected to a head end of the second part of the second pattern, the first part of the second pattern is arranged in parallel to the first part of the first pattern, the second part of the second pattern extends along a second direction, and the second direction is opposite to the first direction; and orthographic projection of a second interconnection structure on the second pattern is located in the second part of the second pattern; and
a third pattern, located between the first pattern and the second pattern.

In the patterned element structure provided in the foregoing embodiment, the first pattern includes the first part and the second part that are perpendicular to each other, the tail end of the first part of the first pattern is connected to the head end of the second part of the first pattern, the second part of the first pattern extends along the first direction, and the orthographic projection of the first interconnection structure of the first pattern on the first pattern is located in the second part of the first pattern; the second pattern includes the first part and the second part that are perpendicular to each other, the tail end of the first part of the second pattern is connected to the head end of the second part of the second pattern, the second part of the second pattern extends along the second direction, the first direction is opposite to the second direction, and the orthographic projection of the second interconnection structure of the second pattern on the second pattern is located in the second part of the second pattern; and the third pattern is located between the first pattern and the second pattern. Compared with a conventional pattern layout structure, a spacing between patterns is smaller in a layout manner of the patterned element structure in the present application. In this way, during a subsequent reliability test after wafer preparation, a smaller spacing can prevent an interconnection structure from falling off and voids in an upper metal film layer caused by falling off of the interconnection structure, thereby improving the reliability of a wafer and prolonging a service life of the wafer.

A second aspect of the present application proposes a patterned array structure, including multiple patterned element structures describe above. The multiple patterned element structures are arranged in an array.

The above description is only an overview of the technical solutions of the present application. To have a clearer understanding of the technical means of the present application and implement the technical solutions according to the content of this specification, the following provides detailed descriptions with reference to the accompanying drawings by using preferred embodiments of the present application.

### Brief Description of the Drawings

To describe the technical solutions in the embodiments of the present application more clearly, the following briefly describes the accompanying drawings required for describing the embodiments. Apparently, the accompanying drawings in the following description show merely some embodiments of the present application, and persons of ordinary skill in the art may still derive other drawings from these accompanying drawings without creative efforts.
FIG. 1 is a schematic structural diagram of a patterned element structure according to an embodiment of the present application;
FIG. 2 is a schematic structural diagram of a patterned element structure according to another embodiment of the present application;
FIG. 3 is a schematic structural diagram of a patterned element structure according to still another embodiment of the present application; and
FIG. 4 is a schematic structural diagram of a patterned array structure according to an embodiment of the present application.

Reference numerals: 10-first pattern, 11-first part of the first pattern, 12-second part of the first pattern, and 13-first interconnection structure;
20-second pattern, 21-first part of the second pattern, 22-second part of the second pattern, and 23-second interconnection structure; and
30-third pattern, 31-first part of the third pattern, 32-second part of the third pattern, and 3 3-third interconnection structure.

### Detailed Description

To facilitate the understanding of the present application, the present application is described more completely below with reference to the related accompanying drawings. The accompanying drawings show the preferred embodiments of the present application. However, the present application is embodied in various forms without being limited to the embodiments described in this specification. On the contrary, these embodiments are provided for a more thorough and comprehensive understanding of content disclosed in the present application.

Unless otherwise defined, all technical and scientific terms used in this specification have the same meaning as commonly understood by persons skilled in the technical field of the present application. The terms used in this specification of the present application are merely for the purpose of describing specific embodiments, rather than to limit the present application. The term "and/or" used in this specification includes any and all combinations of one or more of associated listed items.

It should be understood that when an element or layer is "on", "adjacent to", "connected to", or "coupled to" another element or layer, the element or layer may be directly on the another element or layer, may be adjacent to, connected to, or coupled to the another element or layer, or there may be an intermediate element or layer. In contrast, when an element is "directly on", "directly adjacent to", "directly connected to", or "directly coupled to" another element or layer, there is no intermediate element or layer. It should be understood that although terms "first", "second", "third", and the like may be used to describe various elements, components, areas, layers, and/or parts, these elements, components, areas, layers, and/or parts should not be limited by these terms. These terms are only used to distinguish one element, component, area, layer, or part from another element, component, area, layer, or part. Therefore, without departing from teachings of the present application, a first element, component, area, layer, or part discussed below may be represented as a second element, component, area, layer, or part.

Herein, for the convenience of description, spatial relation terms such as "under", "below", "underlying", "beneath", "on", "above" may be used to describe a relationship between one element or feature shown in a figure and another element or feature. It should be understood that in addition to an orientation shown in the figure, the spatial relation terms are intended to include different orientations of a device in use and operation. For example, if the device in the drawing is turned over, an orientation of an element or feature described as "below" or "beneath" or "under" another element or feature changes to "on" the another element or feature. Therefore, exemplary terms "below" and "under" may include two orientations: "above" and "below". The device may be in another orientation (rotated by 90 degrees or in another orientation) and a spatial description term used herein is interpreted correspondingly.

The terms used herein are only used for describing specific embodiments and do not constitute any limitation in the present application. When used herein, singular forms "a", "an", and "the/this" are also intended to include plural forms, unless otherwise clearly indicated in the context. It should also be understood that, when the terms "composed of' and/or "include" are/is used in this specification, it is determined that a described feature, integer, step, operation, element, and/or component exist/exists, but this does not exclude that one or more other features, integers, steps, operations, elements, components, and/or groups exist or are added. When used herein, the term "and/or" includes any one and all combinations of related listed items.

Embodiments of the present application are described herein with reference to a cross-sectional view as a schematic diagram of an ideal embodiment (and an intermediate structure) of the present application. In this way, a change in a shown shape caused by a fabrication technology, a tolerance, and/or the like may be expected. Therefore, the embodiments of the present application should not be limited to specific shapes of areas shown herein, but include shape deviations caused by fabrication or the like. The areas shown in the figure are used as an example in essence, and shapes thereof are not intended to display actual shapes of areas of a device and are not intended to limit the scope of the present application.

In a BEOL process, a spacing between patterns is excessively wide in a layout manner of a patterned structure prepared by using a conventional technology. Due to an excessively wide spacing, voids are prone to appear in a passivation layer after the passivation layer is deposited and an entire wafer is packaged. Relatively large voids will cause a nearby interconnection structure to fall off. A metal layer located on an upper surface of a silicon oxide film layer is easily pushed up when the interconnection structure falls off, and the metal layer is warped. In this case, metal layers located on the upper surface and a lower surface of the silicon oxide film layer cannot be electrically connected to each other, and there are a lot of gaps near the warped metal layer. Consequently, even if the wafer is packaged, it still cannot work normally in a severe high temperature and high humidity environment.

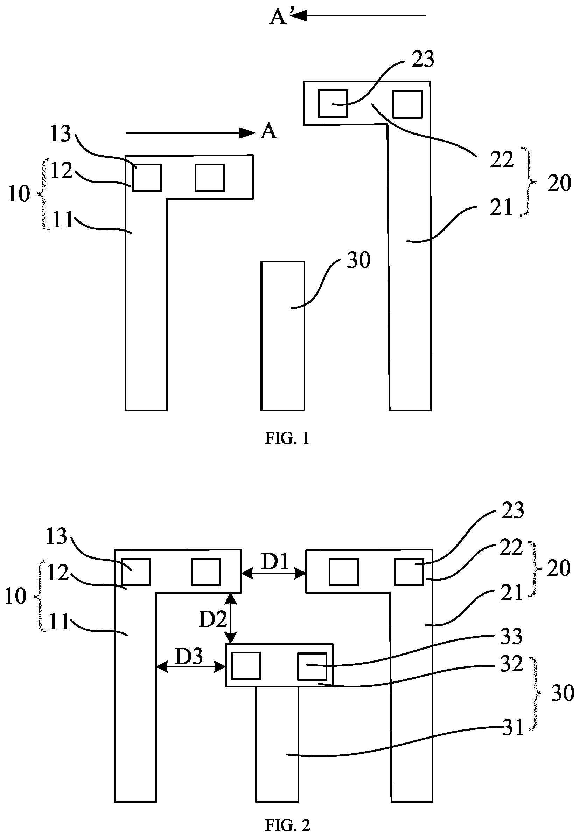

Referring to FIG. 1 to FIG. 4, it should be noted that figures provided in the embodiments only schematically illustrate a basic idea of the present application. Although the figures only show components related to the present application rather than being drawn according to a quantity, shapes, and sizes of the components during actual implementation, forms, the quantity, and a proportion of the components can be changed randomly during actual implementation, and a layout of the components may be more complex.

In an embodiment of the present application, as shown in FIG. 1, a patterned element structure is proposed. The patterned element structure includes a first pattern 10, a second pattern 20, and a third pattern 30. The first pattern 10 includes a first part 11 and a second part 12 that are perpendicular to each other, a tail end of the first part 11 of the first pattern is connected to a head end of the second part 12 of the first pattern, and the second part 12 of the first pattern extends along a first direction A; and orthographic projection of a first interconnection structure 13 on the first pattern 10 is located in the second part 12 of the first pattern. The second pattern 20 includes a first part 21 and a second part 22 that are perpendicular to each other, a tail end of the first part 21 of the second pattern is connected to a head end of the second part 22 of the second pattern, the first part 21 of the second pattern is arranged in parallel to the first part of the first pattern, the second part 22 of the second pattern extends along a second direction A', and the second direction A' is opposite to the first direction A; and orthographic projection of a second interconnection structure 23 on the second pattern 20 is located in the second part 22 of the second pattern. The third pattern 30 is located between the first pattern 10 and the second pattern 20.

In the patterned element structure provided in the foregoing embodiment, the first pattern includes the first part and the second part that are perpendicular to each other, the tail end of the first part of the first pattern is connected to the head end of the second part of the first pattern, the second part of the first pattern extends along the first direction, and the orthographic projection of the first interconnection structure of the first pattern on the first pattern is located in the second part of the first pattern; the second pattern includes the first part and the second part that are perpendicular to each other, the tail end of the first part of the second pattern is connected to the head end of the second part of the second pattern, the second part of the second pattern extends along the second direction, the first direction is opposite to the second direction, and the orthographic projection of the second interconnection structure of the second pattern on the second pattern is located in the second part of the second pattern; and the third pattern is located between the first pattern and the second pattern. Compared with a conventional patterned layout structure, a spacing between patterns is smaller in a layout manner of the patterned element structure in the present application. In this way, during a subsequent reliability test after wafer preparation, a smaller spacing can prevent an interconnection structure from falling off and voids in an upper metal film layer caused by falling off of the interconnection structure, thereby improving the reliability of a wafer and prolonging a service life of the wafer.

For example, the first pattern 10 and the second pattern 20 are both in an inverted L shape, such that the first pattern and the second pattern are close to each other, reducing a spacing between the first pattern 10 and the second pattern. A width of the second part 12 of the first pattern may be the same as a width of the first part 11 of the first pattern, and a width of the second part 22 of the second pattern may be the same as a width of the first part 21 of the second pattern. The second part 12 of the first pattern is rotated 90 degrees relative to a pattern structure of the first part 11 of the first pattern to connect the tail end of the first part 11 of the first pattern to the head end of the second part 12 of the first pattern. This improves a spacing area between patterns to avoid a problem that the interconnection structures fall off.

In an embodiment, the first pattern 10, the second pattern 20, and the third pattern 30 are located on a same metal layer. The patterned element structure further includes multiple layers of first patterns 10 arranged in parallel at intervals, multiple layers of second patterns 20 arranged in parallel at intervals, and multiple layers of third patterns 30 arranged in parallel at intervals, and the first patterns 10, the second patterns 20, and the third patterns 30 are perpendicularly stacked. The first interconnection structure 13 is located between adjacent first patterns 10, and the second interconnection structure 23 is located between adjacent second patterns 10. Specifically, first interconnection structures 13 are formed below and above the second part 12 of the first pattern, and second interconnection structures 23 are formed below and above the second part 22 of the second pattern.

In an embodiment, a dielectric layer (not shown) is arranged between adjacent first patterns 10, between adjacent second patterns 20, and between adjacent third patterns 30, and both the first interconnection structure 13 and the second interconnection structure 23 are located in the dielectric layer.

For example, the dielectric layer may include a first metal layer, a silicon oxide layer, and a second metal layer that are sequentially stacked from bottom to top, and the first interconnection structure and the second interconnection structure penetrate through the silicon oxide layer along a thickness direction. A top part of the first interconnection structure and a top part of the second interconnection structure are in contact with the second metal layer, a bottom part of the first interconnection structure and a bottom part of the second interconnection structure are in contact with the first metal layer, and the second metal layer is electrically connected to the first metal layer through the first interconnection structure and the second interconnection structure. A material of the first metal layer may include, but is not limited to, one of tungsten, copper, or aluminum, or an alloy material of any combination thereof. A material of the second metal layer may include, but is not limited to, one of tungsten, copper, or aluminum, or an alloy material of any combination thereof. A material of the first interconnection structure may include, but is not limited to, one of tungsten, copper, or aluminum, or an alloy material of any combination thereof. A material of the second interconnection structure may include, but is not limited to, one of tungsten, copper, or aluminum, or an alloy material of any combination thereof.

In an embodiment, as shown in FIG. 2, a third pattern 30 is in a T shape. The third pattern 30 includes a first part 31 and a second part 32 that are perpendicular to each other. The first part 31 of the third pattern is perpendicularly connected to the second part 32 of the third pattern. The first part 31 of the third pattern is arranged in parallel to both a first part 11 of a first pattern and a first part 21 of a second pattern, and the second part 32 of the third pattern is arranged in parallel to both a second part 32 of the first pattern and a second part 22 of the second pattern.

Specifically, the third pattern 30 further includes a third interconnection structure 33, and orthographic projection of the third interconnection structure 33 on the third pattern 30 is located in the second part 32 of the third pattern, and is symmetrically located on both sides of a center line of the first part 31 of the third pattern.

Further, there are multiple first interconnection structures 13, multiple second interconnection structures 23, and multiple third interconnection structures 33. The multiple first interconnection structures 13 are arranged at intervals along a length direction of the second part 12 of the first pattern, the multiple second interconnection structures 23 are arranged at intervals along a length direction of the second part 22 of the second pattern, and the multiple third interconnection structures 33 are arranged at intervals along a length direction of the second part 32 of the third pattern. The length direction of the second part 12 of the first pattern is a first direction A, the length direction of the second part 22 of the second pattern is a second direction A', and the length direction of the second part 32 of the third pattern includes the first direction A and the second direction A'. For example, interconnection structures may be arranged at an equal interval along a length direction.

In an embodiment, a length of the second part 32 of the third pattern is greater than a width of the first part 31 of the third pattern, such that a spacing between the second part 32 of the third pattern and the first part 11 of the first pattern is less than a spacing between the first part 31 of the third pattern and the first part 11 of the first pattern.

In an embodiment, a center line of the first part 31 of the third pattern coincides with a center line of the second part 32 of the third pattern; the first pattern 10 and the second pattern 20 are symmetrically distributed along a center line of the third pattern 30; and projection of the second part 12 of the first pattern and projection of the second part 22 of the second pattern in a length direction of the second part 32 of the third pattern separately coincide with the second part 32 of the third pattern partially. Specifically, a projection point of a tail end of the second part 12 of the first pattern in the first direction A is located in the second part 32 of the third pattern, and a projection point of a tail end of the second part 22 of the second pattern in the second direction A' is located in the second part 32 of the third pattern.

In an embodiment, still referring to FIG. 2, there is a first spacing D1 between the tail end of the second part 12 of the first pattern and the tail end of the second part 22 of the second pattern; there is a second spacing D2 between the second part 12 of the first pattern and the second part 32 of the third pattern, and between the second part 22 of the second pattern and the second part 32 of the third pattern; and a ratio of the first spacing D1 to the second spacing D2 is 0.9-1.1. Specifically, D1/D2 is 0.9, 0.95, 1.0, 1.1, or the like. There is a third spacing D3 between the first part 11 of the first pattern and the second part 32 of the third pattern, and between the first part 21 of the second pattern and the second part 32 of the third pattern; and a ratio of the first spacing D1 to the third spacing D3 is 0.9-1.1. Specifically, D1/D3 is 0.9, 0.95, 1.0, 1.1, or the like.

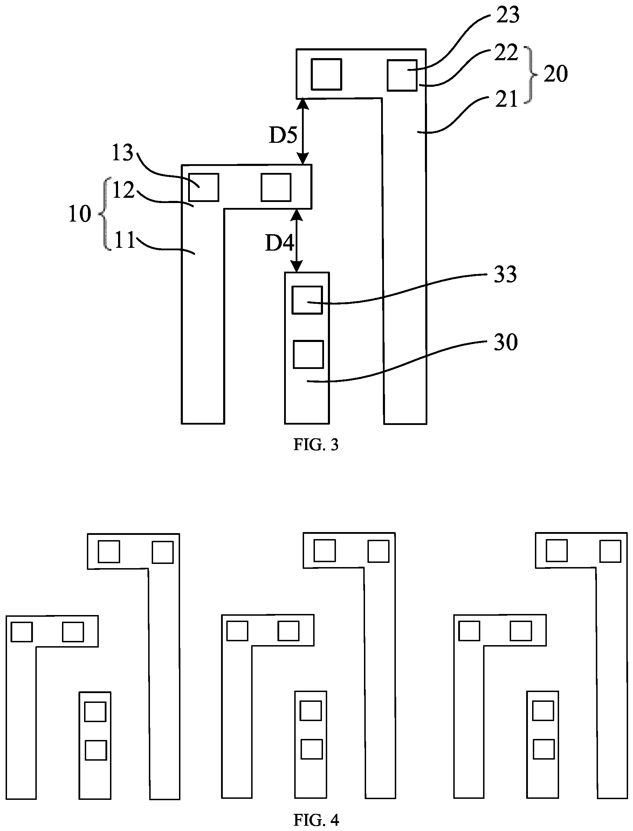

In an embodiment, as shown in FIG. 3, a third pattern 30 is a linear type pattern, and the third pattern 30 is arranged in parallel to both a first part 11 of a first pattern and a first part 21 of a second pattern.

For example, a width of a second part 12 of the first pattern is the same as both a width of the first part 11 of the first pattern and a width of the third pattern 30, and a width of a second part 22 of the second pattern is the same as both a width of the first part 21 of the second pattern and the width of the third pattern 30.

In an embodiment, the third pattern 30 further includes a third interconnection structure 33, and orthographic projection of the third interconnection structure 33 on the third pattern 30 is located in the third pattern 30. There are multiple first interconnection structures 13, multiple second interconnection structures 23, and multiple third interconnection structures 33, the multiple first interconnection structures 13 are arranged at intervals along a length direction of the second part 12 of the first pattern, the multiple second interconnection structures 23 are arranged at intervals along a length direction of the second part 22 of the second pattern, and the multiple third interconnection structures 33 are arranged at intervals along a length direction of the third pattern 30. For example, interconnection structures may be arranged at an equal interval along a length direction.

In an embodiment, projection of the second part 22 of the second pattern and projection of the second part 12 of the first pattern in the length direction of the second part 12 of the first pattern partially coincide with each other; and projection of the third pattern 30, projection of the second part 12 of the first pattern, and projection of the second part 22 of the second pattern in the length direction of the second part 22 of the second pattern partially coincide with each other.

For example, a projection point of a tail end of the second part 12 of the first pattern in a first direction A is located in the third pattern 30, and a projection point of a tail end of the second part 22 of the second pattern in a second direction A' is located in the second part 12 of the first pattern.

In an embodiment, the second part 12 of the first pattern is located between the second part 22 of the second pattern and the third pattern 30. Specifically, there is a fourth spacing D4 between the second part 12 of the first pattern and the third pattern 30, there is a fifth spacing D5 between the second part 22 of the second pattern and the second part 12 of the first pattern, and a ratio of the fourth spacing D4 to the fifth spacing D5 is 0.9-1.1. Specifically, D4/D5 is 0.9, 0.95, 1.0, 1.1, or the like. There is a sixth spacing (not shown in the figure) between the third pattern 30 and the first part 11 of the first pattern, and between the third pattern 30 and the first part 21 of the second pattern 20; and a ratio of the sixth spacing to the fourth spacing D4 and a ratio of the sixth spacing to the fifth spacing D5 are both 0.9-1.1. The spacings that are close to each other are set between the patterns, such that voids can be avoided in a subsequently deposited passivation layer after metal layers and interconnection structures that are sequentially stacked are formed based on the patterns.

For example, blank areas of the first pattern 10, the second pattern 20, and the third pattern 30 form S-shaped space. This can improve a spacing area between the patterns to avoid a problem that the interconnection structures fall off.

In an embodiment of the present application, a patterned array structure is further provided. The patterned array structure includes multiple patterned element structures described above. The multiple patterned element structures are arranged in an array. To be specific, the patterned element structure formed by a first pattern, a second pattern, and a third pattern is used as a unit, and the patterned element structures are sequentially aligned and arranged along a first direction or a second direction, as shown in FIG. 4. This patterned array structure is only shown as an example, and no limitation is set thereto.

It should be noted that the foregoing embodiments are intended for illustrative purposes only rather than limiting the present application.

Each embodiment in this specification is described in a progressive manner. Each embodiment focuses on the difference from other embodiments. For the same and similar parts between the embodiments, mutual reference may be made.

The technical features of the above embodiments can be combined in any manner. For concise description of these embodiments, all possible combinations of all technical features of the embodiments may not be described; however, these combinations of technical features should be construed as disclosed in this specification provided that no contradiction occurs.

Several implementations in the present application are merely described in more detail in the foregoing embodiments, but they should not therefore be construed as limiting the scope of the patent application. It should be noted that persons of ordinary skill in the art can further make several variations and improvements without departing from the conception of the present application. These variations and improvements all fall within the protection scope of the present application. Therefore, the protection scope of the patent application shall be subject to the protection scope defined by the claims.

## Claims

1. A patterned element structure, comprising:
a first pattern, wherein the first pattern comprises a first part and a second part that are perpendicular to each other, a tail end of the first part of the first pattern is connected to a head end of the second part of the first pattern, and the second part of the first pattern extends along a first direction; and orthographic projection of a first interconnection structure on the first pattern is located in the second part of the first pattern;
a second pattern, wherein the second pattern comprises a first part and a second part that are perpendicular to each other, a tail end of the first part of the second pattern is connected to a head end of the second part of the second pattern, the first part of the second pattern is arranged in parallel to the first part of the first pattern, the second part of the second pattern extends along a second direction, and the second direction is opposite to the first direction; and orthographic projection of a second interconnection structure on the second pattern is located in the second part of the second pattern; and
a third pattern, located between the first pattern and the second pattern.

2. The patterned element structure according to claim 1, wherein the third pattern comprises a first part and a second part that are perpendicular to each other, the first part of the third pattern is perpendicularly connected to the second part of the third pattern, the first part of the third pattern is arranged in parallel to both the first part of the first pattern and the first part of the second pattern, and the second part of the third pattern is arranged in parallel to both the second part of the first pattern and the second part of the second pattern.

3. The patterned element structure according to claim 2, wherein orthographic projection of a third interconnection structure on the third pattern is located in the second part of the third pattern, and is symmetrically located on both sides of a center line of the first part of the third pattern.

4. The patterned element structure according to claim 3, wherein there are multiple first interconnection structures, multiple second interconnection structures, and multiple third interconnection structures; the multiple first interconnection structures are arranged at intervals along a length direction of the second part of the first pattern, the multiple second interconnection structures are arranged at intervals along a length direction of the second part of the second pattern, and the multiple third interconnection structures are arranged at intervals along a length direction of the second part of the third pattern.

5. The patterned element structure according to claim 3, wherein a length of the second part of the third pattern is greater than a width of the first part of the third pattern.

6. The patterned element structure according to claim 2, wherein a center line of the first part of the third pattern coincides with a center line of the second part of the third pattern; the first pattern and the second pattern are symmetrically distributed along a center line of the third pattern; and projection of the second part of the first pattern and projection of the second part of the second pattern in a length direction of the second part of the third pattern separately coincide with the second part of the third pattern partially.

7. The patterned element structure according to claim 6, wherein there is a first spacing a distance between a tail end of the second part of the first pattern and a tail end of the second part of the second pattern is; there is a second spacing between the second part of the first pattern and the second part of the third pattern, and between the second part of the second pattern and the second part of the third pattern; and a ratio of the first spacing to the second spacing is 0.9-1.1; and
there is a third spacing between the first part of the first pattern and the second part of the third pattern, and between the first part of the second pattern and the second part of the third pattern; and a ratio of the first spacing to the third spacing is 0.9-1.1.

8. The patterned element structure according to claim 1, wherein the third pattern is linear, and the third pattern is arranged in parallel to the first part of the first pattern and the first part of the second pattern.

9. The patterned element structure according to claim 8, wherein orthographic projection of a third interconnection structure on the third pattern is located in the third pattern.

10. The patterned element structure according to claim 9, wherein there are multiple first interconnection structures, multiple second interconnection structures, and multiple third interconnection structures; the multiple first interconnection structures are arranged at intervals along a length direction of the second part of the first pattern, the multiple second interconnection structures are arranged at intervals along a length direction of the second part of the second pattern, and the multiple third interconnection structures are arranged at intervals along a length direction of the third pattern.

11. The patterned element structure according to claim 8, wherein projection of the second part of the second pattern and projection of the second part of the first pattern, in a length direction of the second part of the first pattern, partially coincide with each other; and projection of the third pattern, projection of the second part of the first pattern, and projection of the second part of the second pattern, in a length direction of the second part of the second pattern, partially coincide with each other.

12. The patterned element structure according to claim 11, wherein the second part of the first pattern is located between the second part of the second pattern and the third pattern.

13. The patterned element structure according to claim 12, wherein there is a fourth spacing between the second part of the first pattern and the third pattern, there is a fifth spacing between the second part of the second pattern and the second part of the first pattern, and a ratio of the fourth spacing to the fifth spacing is 0.9-1.1.

14. The patterned element structure according to claim 1, wherein the first pattern, the second pattern, and the third pattern are located on a same metal layer.

15. The patterned element structure according to claim 1, wherein the patterned element structure comprises multiple layers of first patterns arranged in parallel at intervals, multiple layers of second patterns arranged in parallel at intervals, and multiple layers of third patterns arranged in parallel at intervals; and the first interconnection structure is located between adjacent first patterns, and the second interconnection structure is located between adjacent second patterns.

16. The patterned element structure according to claim 14, wherein a dielectric layer is arranged between adjacent first patterns, between adjacent second patterns, and between adjacent third patterns; and the first interconnection structure and the second interconnection structure are located in the dielectric layer.

17. A patterned array structure, comprising multiple patterned element structures according to any one of claims 1 to 16, wherein the multiple patterned element structures are arranged in an array.
